# EUROPEAN PATENT APPLICATION

(11) **EP 4 676 172 A1**
(43) Date of publication of application: **07.01.2026**
(21) Application number: 24763722.6
(22) Date of filing: 20.02.2024
(51) Int. Cl.: H05K 3/00, B32B 3/30, B32B 15/08, B32B 37/14, H05K 1/18, H05K 3/46

(54) **METHOD FOR PRODUCING WIRING BOARD**

(30) Priority: 28.02.2023 JP 2023030416
(71) Applicant: Mitsui Kinzoku Company, Limited, Tokyo 141-8584 (JP)
(72) Inventor: KITABATAKE, Yukiko, Ageo-shi, Saitama 362-0021 (JP); NAKAMURA, Toshimi, Ageo-shi, Saitama 362-0021 (JP); MATSUURA, Yoshinori, Ageo-shi, Saitama 362-0021 (JP)
(74) Representative: Potter Clarkson
(86) International application number: PCT/JP2024/006082
(87) International publication number: WO 2024/181241

(57) **Abstract**

There is provided a method for manufacturing a wiring board in which unintentional release of a carrier during downsizing is effectively suppressed and a first substrate can be reliably laminated onto a second substrate. This method for manufacturing a wiring board includes the steps of: providing a laminated sheet including a carrier, a release layer, and a metal layer in order, wherein the carrier has a flat region and an uneven region on at least a surface on the metal layer side, and wherein the uneven region is provided in a pattern surrounding the flat region; forming a resin-containing layer on a surface of the metal layer to obtain a carrier-attached first substrate; cutting the carrier-attached first substrate according to the pattern of the uneven region to obtain an individualized carrier-attached first substrate; and laminating the individualized carrier-attached first substrate onto a second substrate so that the carrier is on the outside, to obtain a composite substrate.

## Description

### TECHNICAL FIELD

The present invention relates to a method for manufacturing a wiring board.

### BACKGROUND ART

With the size reduction and functionality enhancement of electronic apparatuses such as portable electronic apparatuses in recent years, further fining (fine pitch) of wiring patterns has been required of printed wiring boards. In order to meet such a requirement, for metal foils for printed wiring board manufacture, those being thinner and having lower surface roughness than before are desired. For example, Patent Literature 1 (JP2005-76091A) discloses a method for manufacturing a carrier-attached superthin copper foil, comprising laminating a release layer and a superthin copper foil in sequence onto a smooth surface of a carrier copper foil in which the average surface roughness Rz is reduced to 0.01 µm or more and 2.0 µm or less, and also discloses that high density superfine wiring (fine pattern) is provided by this carrier-attached superthin copper foil to obtain a multilayer printed wiring board.

It has also been recently proposed to use a glass substrate, a polished metal substrate, or the like as an ultrasmooth carrier instead of a conventionally typically used carrier made of a resin and form a metal layer on this ultrasmooth surface by a vapor phase method such as sputtering in order to achieve further reduction of the thickness and surface roughness of a metal layer in a carrier-attached metal foil. For example, Patent Literature 2 (WO2017/150283) discloses a carrier-attached copper foil comprising a carrier (for example, a glass carrier), a release layer, an antireflection layer, and a superthin copper layer in order, and states that the release layer, the antireflection layer, and the superthin copper layer are formed by sputtering. Patent Literature 3 (WO2017/150284) discloses a carrier-attached copper foil comprising a carrier (for example, a glass carrier), intermediate layers (for example, an adhesion metal layer and a release-assisting layer), a release layer, and a superthin copper layer, and states that the intermediate layers, the release layer, and the superthin copper layer are formed by sputtering. In both Patent Literatures 2 and 3, the layers are formed on a carrier such as glass excellent in surface flatness by sputtering, and thus an extremely low arithmetic mean roughness Ra of 1.0 nm or more and 100 nm or less is achieved on the outside surface of the superthin copper layer.

Meanwhile, during the conveyance of a carrier-attached metal foil, and the like, unexpected release of the metal layer may occur by the contact of the laminated portion of the carrier and the metal layer with other members, and carrier-attached metal foils that can address such a problem are proposed. For example, Patent Literature 4 (WO2022/124116) discloses that an uneven region having a developed interfacial area ratio Sdr of 5% or more and 39% or less is linearly provided as a cutting margin on a surface of a flat glass carrier, and it is stated that thus undesirable release of a metal layer during the cutting of a carrier-attached metal foil, etc. can be prevented.

In recent years, a technique has been proposed in which a redistribution layer containing fine wiring is provided as an interposer between a printed wiring board and a semiconductor chip with different terminal pitches, in order to serve as an intermediary between them. At this time, a method called the transfer method is employed, in which the interposer and the printed wiring board are fabricated separately and then the interposer is joined to the printed wiring board. For example, Patent Literature 5 (US10888001B) discloses a method for manufacturing a wiring board, in which a first substrate having a release layer and a first build-up layer as a redistribution layer formed in this order on a temporary substrate, and a second substrate having second build-up layers on both surfaces are provided separately, and after joining the first build-up layer of the first substrate to one surface of the second substrate, the temporary substrate is removed. In this way, by forming multiple build-up layers on different substrates and then joining them into one, it is said to be possible to alleviate the problem of warpage caused by the manufacture of multiple build-up layers and to improve the yield. Also, Patent Literature 6 (JP2022-170158A) discloses that a multilayer wiring substrate supported by a support is joined with a FC-BGA substrate, and their bonded portion is sealed with a sealing resin layer. It is also disclosed in Patent Literature 6 that the support is released by irradiating the release layer with laser light from the support side. Furthermore, Patent Literature 7 (JP2022-177703A) discloses that a build-up substrate is provided and an interposer having an adhesive layer formed thereon is mounted on the build-up substrate by flip-chip bonding. Patent Literature 7 also discloses that a structure corresponding to the interposer is cut with a slicer or the like.

### CITATION LIST

### PATENT LITERATURE

Patent Literature 1: JP2005-76091A
Patent Literature 2: WO2017/150283
Patent Literature 3: WO2017/150284
Patent Literature 4: WO2022/124116
Patent Literature 5: US10888001B
Patent Literature 6: JP2022-170158A
Patent Literature 7: JP2022-177703A

### SUMMARY OF INVENTION

As disclosed in Patent Literature 5 and the like, when transferring a first substrate (for example, an interposer) to a second substrate (for example, a build-up substrate), it is desirable that the size of the first substrate is equal to or smaller than that of the second substrate, which is the transfer destination. Therefore, for example, when the first substrate is larger than the second substrate, it may be considered to cut and individualize the first substrate in advance so that its size is equal to or smaller than that of the second substrate before transfer. However, if the first substrate includes a resin-containing layer such as a redistribution layer, unintentional release may occur due to, for example, stress in the resin-containing layer during cutting of the first substrate, which can result in failure to proceed to the subsequent transfer step.

The present inventors have now found that, in a method for manufacturing a wiring board, by providing a laminated sheet including, for example, a carrier having an uneven region provided thereon so as to surround a flat region and by forming a resin-containing layer on this laminated sheet to produce a carrier-attached first substrate, unintentional release of the carrier during downsizing is effectively suppressed and the first substrate can be reliably laminated onto the second substrate.

Therefore, an object of the present invention is to provide a method for manufacturing a wiring board in which unintentional release of a carrier during downsizing is effectively suppressed and a first substrate can be reliably laminated onto a second substrate.

The present invention provides the following aspects:

### [Aspect 1]

A method for manufacturing a wiring board, comprising the steps of:
providing a laminated sheet comprising a carrier, a release layer, and a metal layer in order, wherein the carrier has a flat region having a developed interfacial area ratio Sdr of less than 5% as measured in accordance with ISO 25178, and an uneven region having a developed interfacial area ratio Sdr of 5% or more and 39% or less as measured in accordance with ISO 25178, on at least a surface on the metal layer side, and wherein the uneven region is provided in a pattern surrounding the flat region;
forming a resin-containing layer on a surface of the metal layer to obtain a carrier-attached first substrate;
cutting the carrier-attached first substrate according to the pattern of the uneven region to obtain an individualized carrier-attached first substrate; and
laminating the individualized carrier-attached first substrate onto a second substrate so that the carrier is on the outside, to obtain a composite substrate.

### [Aspect 2]

The method for manufacturing a wiring board according to aspect 1,
wherein a width of the pattern of the uneven region in the laminated sheet is more than 1.0 mm, and
wherein the method for manufacturing a wiring board further comprises the step of trimming the individualized carrier-attached first substrate so that the width of the pattern of the uneven region at a periphery of the individualized carrier-attached first substrate is 1.0 mm or less all around, before laminating the individualized carrier-attached first substrate onto the second substrate.

### [Aspect 3]

The method for manufacturing a wiring board according to aspect 1 or 2, further comprising the steps of:
placing the composite substrate on a stage so that the individualized carrier-attached first substrate is on the outside, to make the second substrate adhere to the stage; and
releasing the carrier from the release layer so that the second substrate forms a convex curved surface with a radius of curvature of 200 mm or more and 5000 mm or less, while making the second substrate adhere to the stage.

### [Aspect 4]

The method for manufacturing a wiring board according to any one of aspects 1 to 3, wherein the carrier-attached first substrate has a thickness of 150 µm or more and 3000 µm or less, and the second substrate has a thickness of 300 µm or more and 3000 µm or less.

### [Aspect 5]

The method for manufacturing a wiring board according to any one of aspects 1 to 4, wherein the carrier has a plurality of the flat regions, and wherein the uneven region is provided in a linear pattern defining the flat regions.

### [Aspect 6]

The method for manufacturing a wiring board according to any one of aspects 1 to 5, wherein the carrier is composed of glass, silicon, ceramics, or metal.

### [Aspect 7]

The method for manufacturing a wiring board according to any one of aspects 1 to 6, wherein the resin-containing layer comprises a wiring layer and an insulating layer.

### [Aspect 8]

The method for manufacturing a wiring board according to aspect 7, wherein the insulating layer is composed of an insulating resin.

### [Aspect 9]

The method for manufacturing a wiring board according to any one of aspects 1 to 8, wherein the step of forming the resin-containing layer comprises the steps of:
forming a first wiring layer on a surface of the metal layer; and
alternately forming an insulating layer and a wiring layer on the surface of the laminated sheet on which the first wiring layer has been formed, to obtain a resin-containing layer in which the first wiring layer is incorporated in a form of an embedded wiring layer.

### [Aspect 10]

The method for manufacturing a wiring board according to any one of aspects 1 to 9, wherein the resin-containing layer is an interposer.

### [Aspect 11]

The method for manufacturing a wiring board according to any one of aspects 1 to 10, wherein the second substrate is a build-up substrate.

### [Aspect 12]

The method for manufacturing a wiring board according to any one of aspects 1 to 11, wherein the second substrate comprises a core layer, and wherein the core layer is composed of at least one selected from the group consisting of epoxy resin, bismaleimide-triazine resin, FR-4, FR-5, cyanate ester, polyphenylene derivative, glass, prepreg material, polyimide, polyamide, liquid crystal polymer, epoxy-based build-up material, polytetrafluoroethylene, ceramics, and metal oxide.

### [Aspect 13]

The method for manufacturing a wiring board according to aspect 12, wherein the second substrate comprises a wiring layer and an insulating layer on at least one surface of the core layer.

### [Aspect 14]

The method for manufacturing a wiring board according to any one of aspects 1 to 13, wherein in the laminated sheet, an outermost surface of the metal layer has a flat shape corresponding to a surface shape of the flat region of the carrier, and an uneven shape corresponding to a surface shape of the uneven region of the carrier.

### BRIEF DESCRIPTION OF DRAWINGS

Figure 1 is a process flow diagram showing an example of the method for manufacturing a wiring substrate of the present invention in a schematic cross-sectional view, corresponding to the initial steps (steps (i) to (iii)).
Figure 2 is a process flow diagram showing an example of the method for manufacturing a wiring substrate of the present invention in a schematic cross-sectional view, corresponding to the mid-term steps (steps (iv) to (vi)), which follow the steps shown in Figure 1.
Figure 3 is a process flow diagram showing an example of the method for manufacturing a wiring substrate of the present invention in a schematic cross-sectional view, corresponding to the later steps (steps (vii) to (ix)), which follow the steps shown in Figure 2.
Figure 4 is a perspective view schematically showing a carrier included in a laminated sheet.
Figure 5 is a perspective view schematically showing one aspect of a laminated sheet.
Figure 6 is a schematic cross-sectional view showing the layer configuration of the portion including an uneven region surrounded by the dashed dotted line in the laminated sheet shown in Figure 5.
Figure 7 is a process flow diagram showing an example of a method for forming a resin-containing layer in a schematic cross-sectional view.
Figure 8 is a schematic cross-sectional view showing a carrier-attached first substrate that has been cut on an uneven region, and shows the layer configuration of the portion surrounded by the dashed dotted line in the carrier-attached first substrate shown in Figure 1(iii).
Figure 9 is a schematic cross-sectional view showing an example of a second substrate.
Figure 10 is a process flow diagram showing an example of a method for releasing a carrier in a schematic cross-sectional view.
Figure 11A is a schematic top view showing another example of the method for releasing a carrier.
Figure 11B shows the method for releasing a carrier corresponding to Figure 11A in a schematic cross-sectional view.
Figure 12A is a schematic top view showing another example of the method for releasing a carrier.
Figure 12B shows the method for releasing a carrier corresponding to Figure 12A in a schematic cross-sectional view.

### DESCRIPTION OF EMBODIMENTS

### Definitions

The "developed interfacial area ratio Sdr" or "Sdr" herein is a parameter that represents how much the developed area (surface area) of a defined region increases with respect to the area of the defined region, measured in accordance with ISO 25178. The developed interfacial area ratio Sdr is herein represented as an increase (%) in surface area. A smaller value of this indicates a nearly flat surface shape, and the Sdr of a completely flat surface is 0%. On the other hand, a larger value of this indicates a more uneven surface shape. For example, when the Sdr of a surface is 30%, it is indicated that the surface area of this surface increases from that of a completely flat surface by 30%. The developed interfacial area ratio Sdr can be calculated by measuring the surface profile of a predetermined measurement area (for example, a two-dimensional region of 12690 µm²) on a surface of interest by a commercially available laser microscope. The numerical value of the developed interfacial area ratio Sdr herein is a value measured without using cutoff by an S filter and an L filter.

### Method for Manufacturing Wiring Board

The present invention relates to a method for manufacturing a wiring board. The method of the present invention includes the steps of: (1) provision of a laminated sheet; (2) formation of a resin-containing layer; (3) cutting of the carrier-attached first substrate; (4) trimming of the individualized carrier-attached first substrate, optionally performed; (5) lamination of the individualized carrier-attached first substrate onto a second substrate; (6) release of the carrier, optionally performed; and (7) removal of the release layer and the metal layer, optionally performed.

Each of the steps (1) to (7) will be described below with reference to the drawings.

### (1) Provision of Laminated Sheet

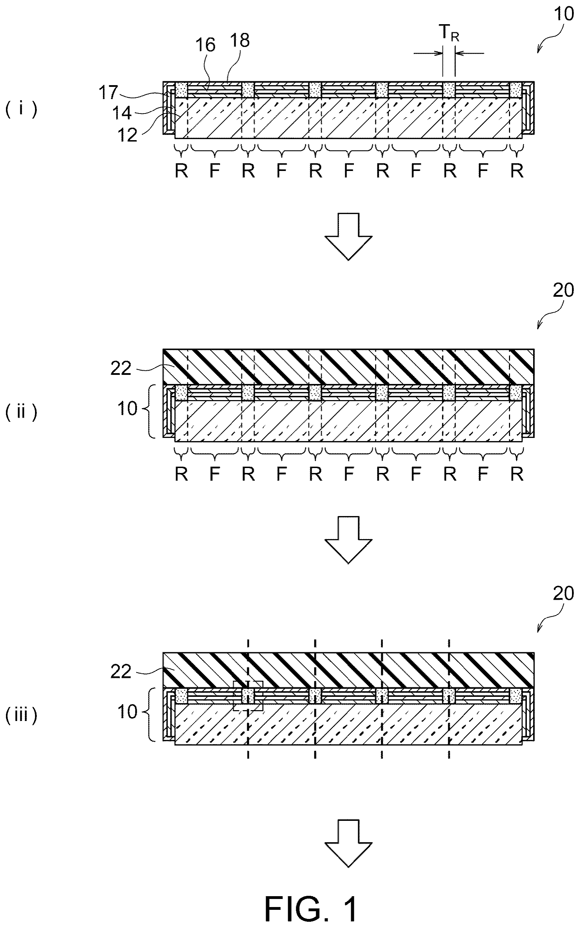

An example of the method for manufacturing a wiring substrate of the present invention is shown in Figures 1 to 3. First, as shown in Figure 1(i), a laminated sheet 10 is provided that includes a carrier 12, a release layer 16, and a metal layer 18 in order. The release layer 16 is a layer that is provided on the carrier 12 and contributes to the release between the carrier 12 and the metal layer 18. The metal layer 18 is a layer composed of metal provided on the release layer 16. The laminated sheet 10 may further have an intermediate layer 14 that can contribute to the improvement of adhesion, between the carrier 12 and the release layer 16. Also, the laminated sheet 10 may further have a functional layer 17 that can function as, for example, a stopper layer during etching, between the release layer 16 and the metal layer 18. Each of the intermediate layer 14, the release layer 16, the functional layer 17, and the metal layer 18 may be a single layer composed of one layer or a multilayer composed of two or more layers.

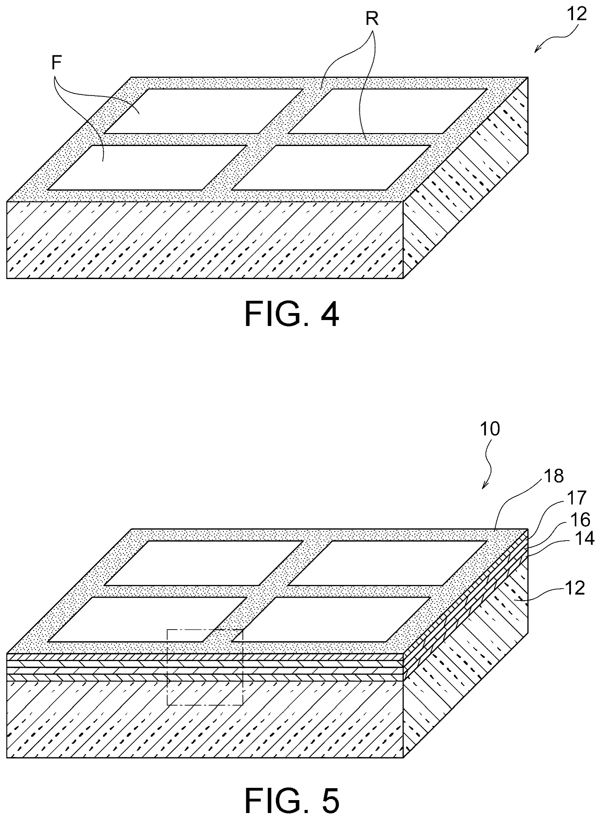

As shown in Figure 4, the carrier 12 has one or a plurality of flat regions F having a developed interfacial area ratio Sdr of less than 5%, and an uneven region R having a developed interfacial area ratio Sdr of 5% or more and 39% or less, on at least the surface on the metal layer 18 side. This uneven region R is provided in a pattern surrounding the flat region F.

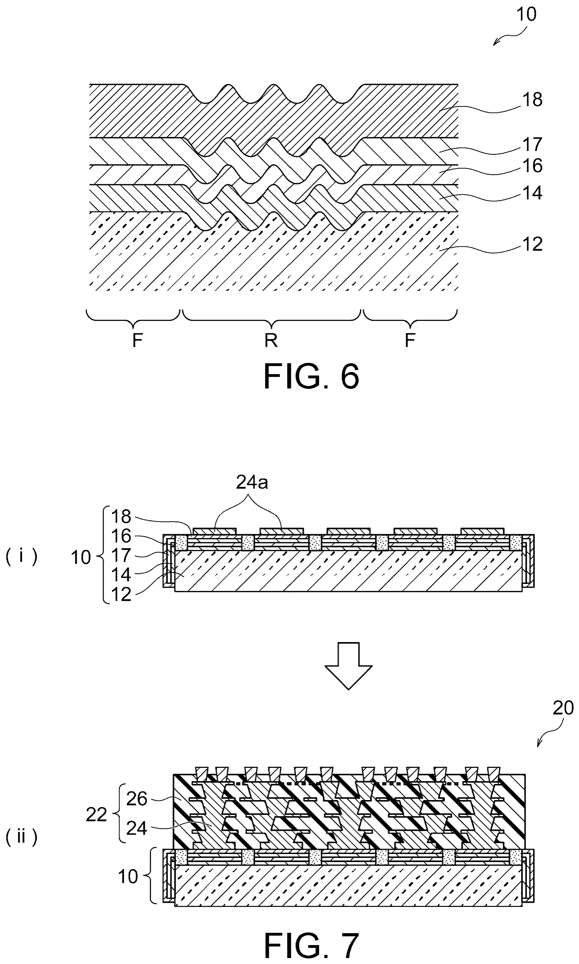

The carrier 12 has the flat region F having a small developed interfacial area ratio Sdr, and thus, as shown in Figure 5 and Figure 6, the surface on the flat region F of the metal layer 18 laminated on the carrier 12 via the release layer 16 also has a flat shape. This flat surface of the metal layer 18 allows the formation of a highly fine wiring pattern or the like. The carrier 12 also has the uneven region R having a large developed interfacial area ratio Sdr, and an anchor effect due to this unevenness can increase the release strength in the portion formed on the uneven region R of the release layer 16, the metal layer 18, and a resin-containing layer 22 described later.

The flat region F (each of the plurality of flat regions F when the carrier 12 has the plurality of flat regions F) of the carrier 12 has a developed interfacial area ratio Sdr of less than 5%, preferably 0.01% or more and 4.0% or less, more preferably 0.03% or more and 3.0% or less, further preferably 0.05% or more and 1.0% or less, particularly preferably 0.07% or more and 0.50% or less, and most preferably 0.08% or more and 0.50% or less. The developed interfacial area ratio Sdr of the flat region F smaller in this manner can provide a desirably lower developed interfacial area ratio Sdr on the outermost surface (that is, the surface opposite to the release layer 16) of the metal layer 18 laminated on the carrier 12 and thus is suitable for forming, for example, a wiring pattern highly fine to such an extent that the line/space (L/S) is 13 µm or less/13 µm or less (for example, 12 µm/12 µm to 2 µm/2 µm), in a resin-containing layer 22 formed on the laminated sheet 10.

The uneven region R of the carrier 12 has a developed interfacial area ratio Sdr of 5% or more and 39% or less, preferably 6% or more and 36% or less, more preferably 7% or more and 32% or less, further preferably 7% or more and 25% or less, and particularly preferably 8% or more and 22% or less. Thus, the ease of being released from the release layer 16 in the uneven region R decreases (the adhesion improves). As a result, after the formation of the resin-containing layer 22, when the carrier-attached first substrate 20 is cut according to the pattern of the uneven region R, good release strength on the cutting surface(s) can be ensured, and undesirable release of the carrier 12 and the like accompanying the cutting can be effectively suppressed. Also, a pointed portion and a cracked portion are less likely to occur on the carrier 12 surface, and therefore it is possible to reduce the number of the particulate broken pieces of the carrier that occur when the laminated sheet 10 is cut. Moreover, when the Sdr is within the above range, a decrease in the strength of the carrier 12 can also be effectively suppressed. The release strength of the carrier 12 in the uneven region R is preferably 20 gf/cm or more and 3000 gf/cm or less, more preferably 25 gf/cm or more and 2000 gf/cm or less, further preferably 30 gf/cm or more and 1000 gf/cm or less, particularly preferably 35 gf/cm or more and 500 gf/cm or less, and most preferably 50 gf/cm or more and 300 gf/cm or less. When the release strength of the carrier 12 in the uneven region R is in this range, unintentional release of the carrier 12 and the like from an end or cutting surface of the carrier-attached first substrate 20 can be more effectively suppressed, and the uneven region R can be formed with good productivity. This release strength is a value measured in accordance with JIS Z 0237-2009.

When the carrier 12 has the plurality of flat regions F, the uneven region R is preferably provided in a linear pattern defining the plurality of flat regions F. The pattern of the uneven region R is preferably provided in a lattice form, a fence form, or a cross form in terms of easily defining the plurality of flat regions F in an equal shape and size suitable for a substrate. Especially, the pattern of the uneven region R is particularly preferably provided in a lattice form. Thus, the peripheries of the individual flat regions F can be surrounded by the uneven region R, and therefore the starting point of release is less likely to be caused at the ends of each carrier-attached first substrate 20' individualized by cutting. Also, the size of the individualized carrier-attached first substrate 20' is desirably equal to or smaller than that of a second substrate 30, which is the transfer destination. In other words, it is preferable to design the flat regions F and the uneven region R of the laminated sheet 10 so as to match the size of the second substrate 30.

The width of the pattern, T_{R}, of the uneven region R is preferably more than 1.0 mm, more preferably more than 1.0 mm and 50 mm or less, more preferably 1.5 mm or more and 45 mm or less, further preferably 2.0 mm or more and 40 mm or less, and particularly preferably 2.5 mm or more and 35 mm or less. When the width of the pattern is in such a range, unintentional release of the carrier 12 and the like from the cutting surface can be effectively suppressed. Also, the positioning of cutting means such as a cutter in the uneven region R is easily performed, and cutting is also easily performed, and various advantages of the uneven region R can be desirably achieved while much of the flat region F is ensured.

From the viewpoint of sufficiently ensuring a region that can provide the metal layer 18 with flatness necessary for the formation of a fine pattern (that is, the flat region F), the ratio of the area of the uneven region R to the total area of the flat region F and uneven region R of the carrier 12 is preferably 0.01 or more and 0.50 or less, more preferably 0.02 or more and 0.45 or less, further preferably 0.05 or more and 0.40 or less, and particularly preferably 0.10 or more and 0.35 or less.

The method for manufacturing the laminated sheet 10 is not particularly limited, and can be fabricated by using an already known method for manufacturing a carrier-attached metal foil (see, for example, Patent Literatures 2 to 4) as is or by modifying it as appropriate. For example, the laminated sheet 10 can be manufactured by (i) providing a carrier, (ii) performing roughening treatment on at least the outer peripheral portion of a carrier surface, and (iii) forming various layers such as a release layer and a metal layer on the carrier. Other preferred aspects of the laminated sheet 10 will be described later.

### (2) Formation of Resin-Containing Layer

A resin-containing layer 22 is formed on the surface of the metal layer 18 of the laminated sheet 10 to obtain a carrier-attached first substrate 20 (Figure 1(ii)). The carrier-attached first substrate 20 is in a form that can be handled by itself alone, and hence the resin-containing layer 22 can be transferred to a second substrate 30, as described later.

The thickness of the carrier-attached first substrate 20 is preferably 150 µm or more and 3000 µm or less, more preferably 170 µm or more and 2000 µm or less, further preferably 180 µm or more and 1600 µm or less, and particularly preferably 200 µm or more and 1500 µm or less.

The resin-containing layer 22 preferably includes a wiring layer 24 and an insulating layer 26 (see Figure 7(ii)). In other words, the resin-containing layer 22 is preferably an interposer (a redistribution layer). That is, the resin-containing layer 22 (first substrate) is an interposer, which allows electrical connection between the chip electrodes disposed on the semiconductor chip and the terminals disposed on the second substrate 30 at a pitch larger than that for the chip electrodes.

The method for forming the resin-containing layer 22 is not particularly limited, but for example, the resin-containing layer 22 can be preferably formed according to the process shown in Figure 7. The process shown in Figure 7 includes the steps of (i) forming a first wiring layer and (ii) alternately forming an insulating layer and a wiring layer.

First, as shown in Figure 7(i), a first wiring layer 24a is formed on the surface of the metal layer 18. The formation of the first wiring layer 24a may be performed according to a known method, and is, for example, performed through the formation of a photoresist layer, the formation of an electroplating layer, the stripping of the photoresist layer, and, optionally, flash etching. Next, as shown in Figure 7(ii), an insulating layer 26 and a wiring layer 24 are alternately formed on the surface of the laminated sheet 10 on which the first wiring layer 24a has been formed, to obtain a resin-containing layer 22 in which the first wiring layer 24a is incorporated in the form of an embedded wiring layer. The wiring layer 24 may be of at least two layers (first wiring layer 24a and second wiring layer), and the insulating layer 26 may be of one or more layers. In other words, the resin-containing layer 22 preferably has at least two layers of the wiring layer 24 together with at least one layer of the insulating layer 26. The sequential laminated structure composed of the wiring layer 24 and the insulating layer 26 is generally referred to as a build-up layer or build-up wiring layer. From the viewpoint of preventing damage to the resin-containing layer 22 in the release process of the carrier 12, etc. described later, it is preferable that the insulating layer 26 be composed of an insulating resin. On the wiring layer 24 at the top surface of the resin-containing layer 22, a solder resist layer and/or a surface metal treatment layer (for example, OSP (organic solderability preservative) treatment layer, Au plating layer, Ni-Au plating layer, or the like) may be formed, if necessary.

The thickness of the resin-containing layer 22 is preferably 1 µm or more and 200 µm or less, more preferably 3 µm or more and 180 µm or less, further preferably 5 µm or more and 150 µm or less, and particularly preferably 10 µm or more and 100 µm or less. Also, the size of the resin-containing layer 22 is preferably 10 cm square or more, more preferably 20 cm square or more, and further preferably 25 cm square or more. The upper limit of the size of the resin-containing layer 22 is not particularly limited, and an example of one rough standard of the upper limit includes 1000 cm square. The size of the resin-containing layer 22 is typically larger than that of the second substrate 30 described later, and hence it is desirable to cut and individualize the carrier-attached first substrate 20 to a size equal to or smaller than that of the second substrate 30, as described later.

### (3) Cutting of Carrier-Attached First Substrate

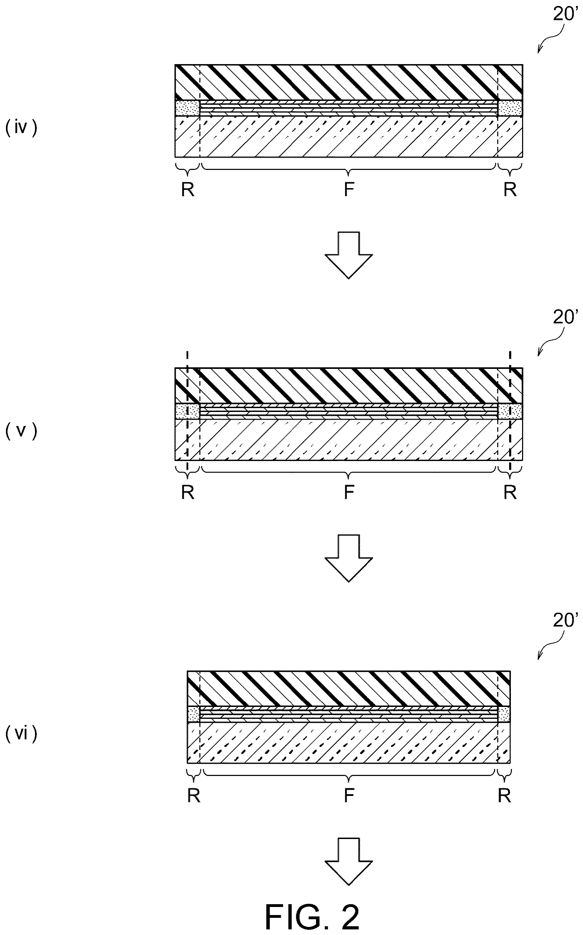

The carrier-attached first substrate 20 is cut according to the pattern of the uneven region R (Figure 1(iii)). Thus, an individualized carrier-attached first substrate 20' is obtained (Figure 2(iv)).

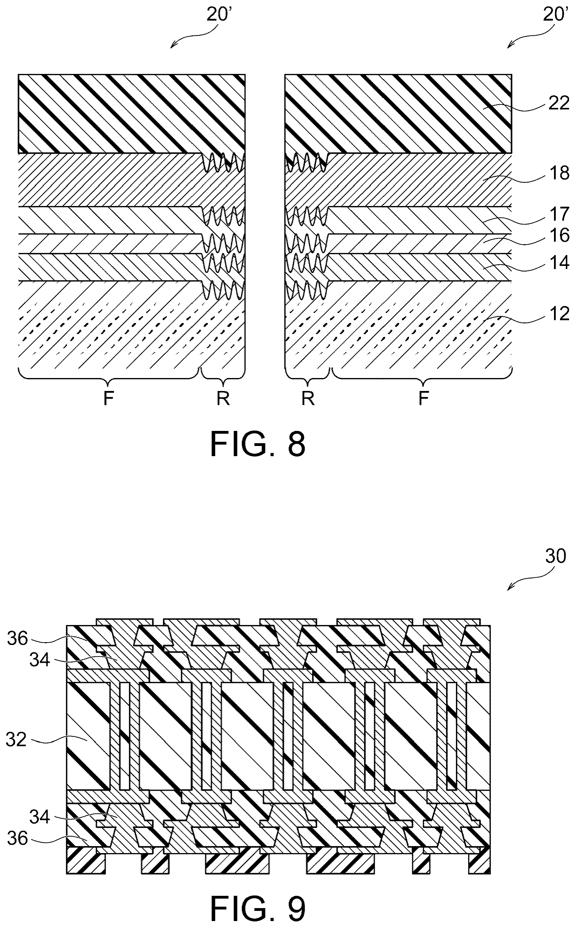

As described above, in the case of substrates including conventional resin-containing layers (such as interposers), there is a problem that unintentional release of the carrier and the like is easily caused by the stress in the resin-containing layer when cutting such substrates. The manufacturing method of the present invention effectively eliminates this problem. Here, the layer configuration at the cutting place of the individualized carrier-attached first substrate 20' is shown in Figure 8. As shown in Figure 8, in the carrier-attached first substrate 20', the cutting surface is present in the uneven region R, and therefore the release strength between the carrier 12 and the resin-containing layer 22 on the cutting surface is high. The individualized carrier-attached first substrate 20' has a structure in which the uneven region R surrounds the flat regions F (so-called bag-bound structure), and thus, it can be said that the above release strength is high throughout the entire cutting surface. For this reason, even when subjected to stress from the resin-containing layer 22, unintentional release of the carrier 12 from an end or the like of the individualized carrier-attached first substrate 20' can be extremely effectively prevented. As a result, it is possible to reliably laminate the individualized carrier-attached first substrate 20' onto the second substrate 30.

For the cutting of the carrier-attached first substrate 20, a known method may be employed with no particular limitation. For example, the carrier-attached first substrate 20 can be preferably individualized by inserting the blade of a cutting tool such as a cutter or a machine tool such as a cutting blade from a direction generally perpendicular to the main surface of the carrier 12 (for example, within the range of 90° ± 5°).

The size of the individualized carrier-attached first substrate 20' is preferably equal to or smaller than that of the second substrate 30, which is the transfer destination. For example, the size of the individualized carrier-attached first substrate 20' is preferably 10 mm square or more and 200 mm square or less, more preferably 15 mm square or more and 100 mm square or less, and further preferably 20 mm square or more and 70 mm square or less.

The individualized carrier-attached first substrate 20' has a structure in which the uneven region R surrounds the flat regions F as described above. The width of the pattern of the uneven region R at the periphery of the individualized carrier-attached first substrate 20' is preferably more than 0.5 mm, more preferably 1.0 mm or more, further preferably more than 1.0 mm, particularly preferably 1.2 mm or more, and most preferably 1.5 mm or more all around. Also, the width of the pattern of the uneven region R is preferably 10 mm or less, more preferably 5.0 mm or less, further preferably 3.0 mm or less, and particularly preferably 2.0 mm or less all around. By cutting the carrier-attached first substrate 20 so that the uneven region has such a pattern width, the release of the carrier 12 during cutting can be still further effectively prevented.

### (4) Trimming of Individualized Carrier-Attached First Substrate (Optional Step)

Optionally, the individualized carrier-attached first substrate 20' may be trimmed (Figure 2(v)). This trimming is performed so that the width of the pattern of the uneven region R at the periphery of the individualized carrier-attached first substrate 20' is preferably 1.0 mm or less (Figure 2(vi)), more preferably 0.10 mm or more and 0.98 mm or less, further preferably 0.20 mm or more and 0.95 mm or less, and particularly preferably 0.30 mm or more and 0.90 mm or less all around.

From the viewpoint of handleability of the individualized carrier-attached first substrate 20', it is desirable that the carrier 12 is not released until the resin-containing layer 22 (first substrate) is transferred to the second substrate 30. In this respect, since unintentional release of the carrier 12 is likely to occur when cutting the carrier-attached first substrate 20, where the stress in the resin-containing layer 22 is large, it is desirable to ensure a large width of the pattern of the uneven region R (for example, more than 1.0 mm) to keep the release strength between the carrier 12 and the resin-containing layer 22 at the cutting surface particularly high. On the other hand, after laminating the resin-containing layer 22 onto the second substrate 30, it is desirable that the carrier 12 can be released easily. That is, after cutting the carrier-attached first substrate 20 and before laminating it onto the second substrate 30, it is preferable to narrow the width of the pattern of the uneven region R by the above trimming, so that the release strength between the carrier 12 and the resin-containing layer 22 at the cutting surface is made moderate. In this way, by separately performing the cutting of the carrier-attached first substrate 20 and the trimming of the individualized carrier-attached first substrate 20', unintentional release of the carrier 12 during cutting can be effectively prevented, while desirable release of the carrier 12 after lamination onto the second substrate 30 described later can be performed easily.

For the trimming of the individualized carrier-attached first substrate 20', a known method may be employed with no particular limitation. For example, the individualized carrier-attached first substrate 20' can be preferably trimmed by inserting the blade of a cutting tool such as a cutter or a machine tool such as a cutting blade from a direction generally perpendicular to the main surface of the carrier 12 (for example, within the range of 90° ± 5°).

### (5) Lamination of Individualized Carrier-Attached First Substrate onto Second Substrate

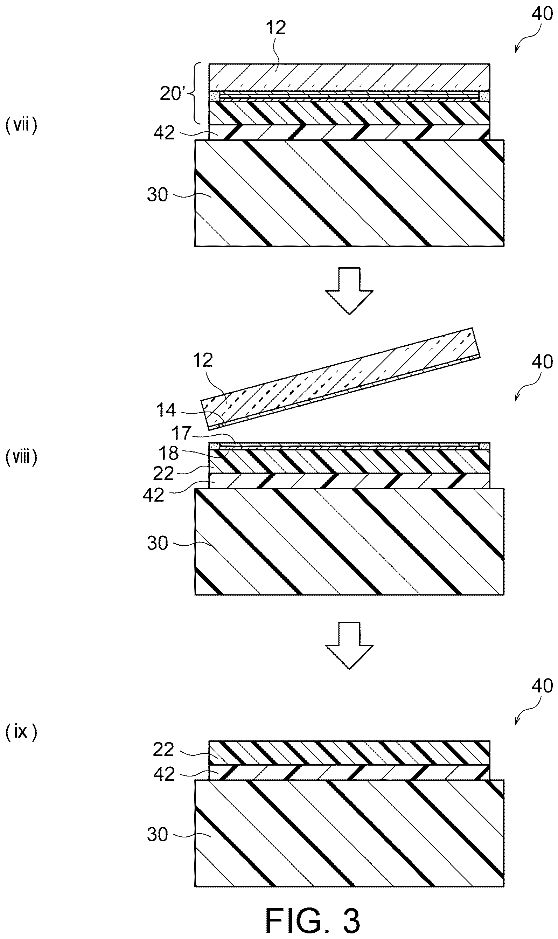

The individualized carrier-attached first substrate 20' is laminated onto a second substrate 30 so that the carrier 12 is on the outside, to obtain a composite substrate 40 (Figure 3(vii)).

At this time, it is preferable to electrically connect the resin-containing layer 22 with the second substrate 30 using a known method. For example, solder may be used to join the resin-containing layer 22 and the second substrate 30. Alternatively, the resin-containing layer 22 and the second substrate 30 may be joined using an adhesive layer 42, as shown in Figure 3(vii). An example of the adhesive layer 42 is a non-conductive film (NCF) with epoxy resin as the main agent.

The second substrate 30 can be any known circuit substrate, but is preferably a build-up substrate. An example of such a build-up substrate is shown in Figure 9. The second substrate 30 shown in Figure 9 includes a core layer 32, a wiring layer 34, and an insulating layer 36. That is, a build-up layer in which wiring layers 34 and insulating layers 36 are formed alternately is provided on both surfaces of the core layer 32.

The core layer 32 is a layer for improving the strength of the substrate. The core layer 32 is preferably composed of epoxy resin, bismaleimide-triazine resin, FR-4 (Flame Retardant Type 4), FR-5 (Flame Retardant Type 5), cyanate ester, polyphenylene derivative, glass, prepreg material, polyimide, polyamide, liquid crystal polymer, epoxy-based build-up material, polytetrafluoroethylene, ceramics, metal oxide, or a combination thereof. The core layer 32 can itself be a multilayer substrate including multiple wiring layers. Also, the core layer 32 may have through holes and/or partial through holes (IVH). Through holes and partial through holes may electrically connect conductors in the board thickness direction by plating or other means.

The second substrate 30 preferably includes the wiring layer 34 and the insulating layer 36 on at least one surface of the core layer 32. That is, the wiring layer 34 and the insulating layer 36 may be provided on one surface of the core layer 32, or may be provided on both surfaces of the core layer 32. The formation of the wiring layer 34 and the insulating layer 36 may be performed using a known method, and for example, the build-up method described above can be preferably employed. On the wiring layer 34 at the top surface of the second substrate 30, a solder resist layer and/or a surface metal treatment layer (for example, OSP treatment layer, Au plating layer, Ni-Au plating layer, or the like) may be formed, if necessary.

The thickness of the second substrate 30 is preferably 300 µm or more and 3000 µm or less, more preferably 350 µm or more and 2800 µm or less, further preferably 400 µm or more and 2700 µm or less, and particularly preferably 450 µm or more and 2500 µm or less. The size of the second substrate 30 is preferably 40 mm square or more and 200 mm square or less, more preferably 45 mm square or more and 150 mm square or less, and further preferably 50 mm square or more and 100 mm square or less.

### (6) Release of Carrier (Optional Step)

Optionally, the carrier 12 may be released from the composite substrate 40 (Figure 3(viii)). The release of the carrier 12 may be done by a physical method, or may be done by release with laser (laser lift-off, LLO). The physical method is a method of separating the carrier 12 by peeling it off from the composite substrate 40 by hand, jig, machine, or other means.

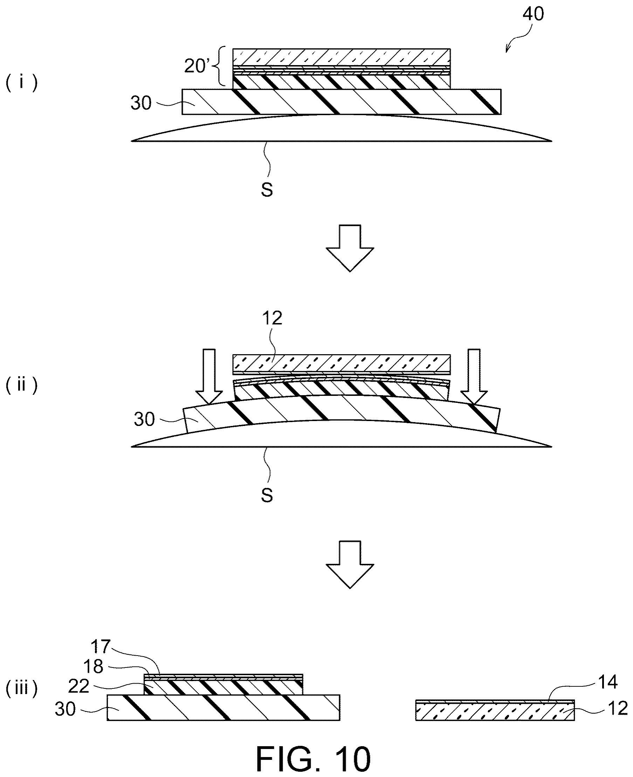

An example of the preferred method for releasing the carrier 12 is shown in Figure 10. First, as shown in Figure 10(i), the composite substrate 40 is placed on a stage S so that the individualized carrier-attached first substrate 20' is on the outside, to make the second substrate 30 adhere to the stage S. This stage S has a convex curved surface with a radius of curvature of 200 mm or more and 5000 mm or less, preferably 300 mm or more and 3500 mm or less, further preferably 350 mm or more and 3000 mm or less, particularly preferably 600 mm or more and 1900 mm or less, and most preferably 1000 mm or more and 1800 mm or less. Therefore, as shown in Figure 10(ii), by making the second substrate 30 adhere to the convex curved surface of the stage S, the second substrate 30 also forms a convex curved surface corresponding to the above radius of curvature. This causes a force to be applied to the composite substrate 40 in a direction that separates the second substrate 30 from the carrier 12. Then, while making the second substrate 30 adhere to the stage, the carrier 12 is released from the release layer 16 so that the second substrate 30 forms a convex curved surface with the above radius of curvature (Figure 10(iii)). In this way, by releasing the carrier 12 so that the second substrate 30 forms a convex curved surface with a radius of curvature of 200 mm or more, the concentration of stress and the occurrence of damage due to a small radius of curvature can be avoided. Furthermore, by setting the above radius of curvature of the convex curved surface to 5000 mm or less and by performing the above release while making the second substrate 30 adhere to the stage S, the release of the carrier 12 can be performed extremely easily and extremely efficiently, which significantly improves productivity.

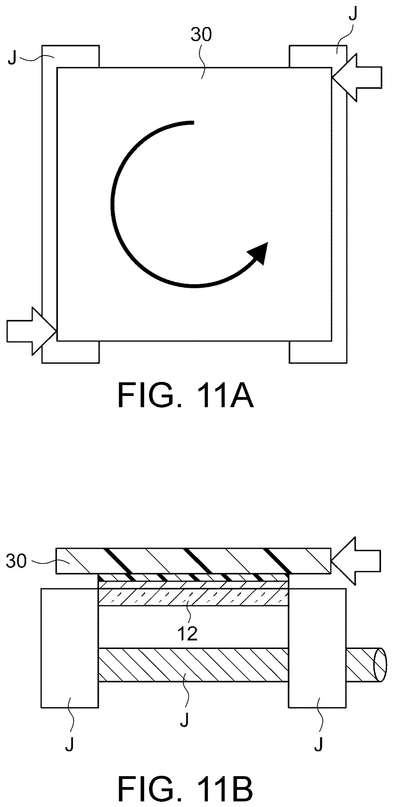

Another example of the method for releasing the carrier 12 is shown in Figure 11A and Figure 11B. In the method shown in Figure 11A and Figure 11B, first, the carrier 12 side of the composite substrate 40 is fixed using a fixing jig J. An example of the fixing jig J is a clamp. Then, with the carrier 12 fixed, by applying a force in the direction in which the second substrate 30 rotates, the carrier 12 can be released from the composite substrate 40 at the position of the release layer 16. For example, as shown in Figure 11A, forces may be applied in opposite directions from opposite corners of the second substrate 30 to each other so that the composite substrate 40 twists. In this way, the release of the carrier 12 can be performed extremely easily and extremely efficiently.

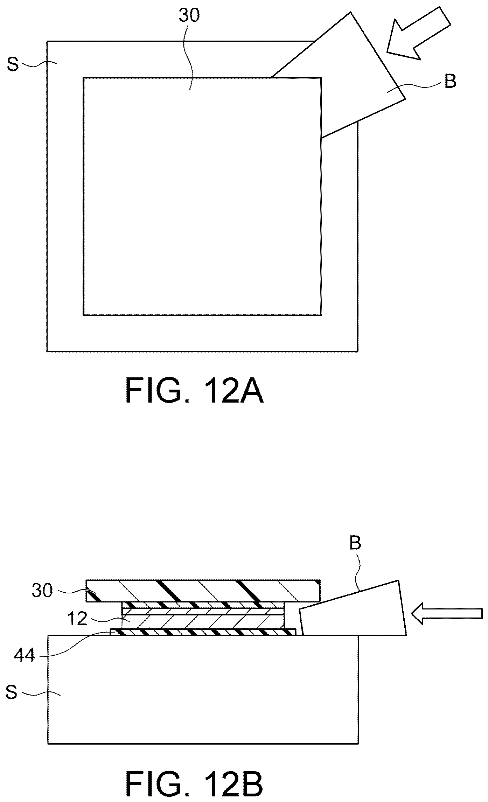

Still another example of the method for releasing the carrier 12 is shown in Figure 12A and Figure 12B. In the method shown in Figure 12A and Figure 12B, first, the carrier 12 side of the composite substrate 40 is fixed to a stage S using adhesive tape 44 or the like. Next, with the carrier 12 fixed, a plate member B is inserted between the second substrate 30 and the stage S. Then, using this plate member B, by applying a force in the direction in which the carrier 12 and the second substrate 30 are separated, the carrier 12 can be released from the composite substrate 40 at the position of the release layer 16. For example, as shown in Figure 12B, the plate member B may have a tapered shape, and the plate member B may be inserted between the second substrate 30 and the stage S from the thinner side. In this way, the force applied to the second substrate 30 increases as the plate member B is inserted, resulting in smooth release of the carrier 12.

### (7) Removal of Release Layer and Metal Layer (Optional Step)

Optionally, the remaining release layer 16 on the composite substrate 40 may be removed. The method for removing the release layer 16 is not particularly limited, and a known method may be selected as appropriate depending on the material of the release layer 16. For example, if the release layer 16 is a carbon layer, the release layer 16 can be preferably removed by performing oxygen plasma treatment on the composite substrate 40. In particular, by constituting the release layer 16 with a material that can be released without the use of laser, the plasma treatment time can be shortened, resulting in minimized damage to the composite substrate 40.

Optionally, the exposed functional layer 17 (if present) and the metal layer 18 may be removed by etching after the release of the carrier 12 or the removal of the release layer 16 (Figure 3(ix)). After removal of the metal layer 18 and the like, mounting pads, solder bumps, and the like may be formed on the surface of the resin-containing layer 22 by a known method, and electronic components such as semiconductor chips may be mounted. In other words, the resin-containing layer 22 is preferably an interposer (a redistribution layer) that relays between the second substrate 30 and semiconductor chips or the like, as described above. In any case, the composite substrate 40 can be made into a wiring board as a final product by performing various known treatments on it.

### Laminated Sheet

As described above with reference to Figure 5, the laminated sheet 10 used in the method of the present invention has the carrier 12, optionally the intermediate layer 14, the release layer 16, optionally the functional layer 17, and the metal layer 18 in order.

As described above, the carrier 12 has the flat region F and the uneven region R each having a Sdr controlled to be within a predetermined range, and the uneven region R is provided in a pattern surrounding the flat region F. The carrier 12 is preferably composed of glass, silicon, ceramics, or metal, more preferably glass, silicon, or ceramics, and further preferably glass or silicon. The carrier 12 composed of silicon may be anything as long as it includes Si as an element, and a SiO₂ substrate, a SiN substrate, a Si single crystal substrate, a Si polycrystalline substrate, and the like can be applied. Preferred examples of the metal constituting the carrier 12 include aluminum and aluminum alloys (for example, duralumin (for example, A2017, A2024, and A7075 in the JIS standard)), stainless steel, copper and copper alloys (for example, bronze, phosphor copper, copper nickel alloys, copper titanium alloys, and the like), titanium and titanium alloys, and nickel and nickel alloys. The form of the carrier 12 may be any of a sheet, a film, and a plate. The carrier 12 may be a laminate of these sheets, films, plates, and the like. For example, the carrier 12 is preferably one that can function as a support having rigidity, such as a SiO₂ substrate, a Si single crystal substrate, or a glass plate. More preferably, from the viewpoint of preventing the warpage of the laminated sheet 10 in a process involving heating, the carrier 12 is a Si single crystal substrate or a glass plate having a coefficient of thermal expansion (CTE) of less than 25 ppm/K (typically 1.0 ppm/K or more and 23 ppm/K or less). From the viewpoint of handleabililty and ensuring flatness during chip mounting, the Vickers hardness of the carrier 12 is preferably 500 HV or more and 3000 HV or less, more preferably 600 HV or more and 2000 HV or less. When glass is used as the carrier, advantages are that it is lightweight, has a low coefficient of thermal expansion, has high insulating properties, has high rigidity, and has a flat surface and therefore the surface of the metal layer 18 can be extremely smoothed. In addition, when the carrier is glass, advantages are that it is excellent in visibility when image inspection is performed after a wiring layer is formed, that it has surface flatness (coplanarity) advantageous during electronic device mounting, that it has chemical resistance in desmear and various plating steps in a resin-containing layer 22 formation process, and that a chemical separation method can be adopted when the carrier 12 is released from the composite substrate 40. The carrier 12 is preferably glass comprising SiO₂, more preferably glass comprising 50% by weight or more of SiO₂, further preferably 60% by weight or more of SiO₂. Preferred examples of the glass constituting the carrier 12 include quartz glass, borosilicate glass, alkali-free glass, soda lime glass, aluminosilicate glass, and combinations thereof, more preferably borosilicate glass, alkali-free glass, soda lime glass, and combinations thereof, particularly preferably alkali-free glass, soda lime glass, and combinations thereof, and most preferably alkali-free glass. The carrier 12 is preferably composed of borosilicate glass, alkali-free glass, or soda lime glass because the chipping of the carrier 12 can be reduced when the carrier-attached first substrate 20 is cut. The alkali-free glass is glass containing substantially no alkali metals that comprises silicon dioxide, aluminum oxide, boron oxide, and alkaline earth metal oxides such as calcium oxide and barium oxide as main components and further contains boric acid. An advantage of this alkali-free glass is that it has a low coefficient of thermal expansion in the range of 3 ppm/K or more and 5 ppm/K or less and is stable in a wide temperature zone of 0°C to 350°C, and therefore the warpage of the glass in a process involving heating can be minimized. The thickness of the carrier 12 is preferably 100 µm or more and 2000 µm or less, more preferably 300 µm or more and 1800 µm or less, and further preferably 400 µm or more and 1100 µm or less. When the carrier 12 has a thickness within such a range, the thinning of a resin-containing layer, and the reduction of warpage that occurs during electronic component mounting can be achieved while suitable strength that does not hinder handling is ensured.

The optionally provided intermediate layer 14 is a layer interposed between the carrier 12 and the release layer 16 and contributing to ensuring the adhesion between the carrier 12 and the release layer 16. Examples of the metal constituting the intermediate layer 14 include Cu, Ti, Al, Nb, Zr, Cr, W, Ta, Co, Ag, Ni, In, Sn, Zn, Ga, Mo, and combinations thereof (hereinafter referred to as a metal M), preferably Cu, Ti, Al, Nb, Zr, Cr, W, Ta, Co, Ag, Ni, Mo, and combinations thereof, more preferably Cu, Ti, Zr, Al, Cr, W, Ni, Mo, and combinations thereof, further preferably Cu, Ti, Al, Cr, Ni, Mo, and combinations thereof, and particularly preferably Cu, Ti, Al, Ni, and combinations thereof. The intermediate layer 14 may be a pure metal or an alloy. The metal constituting the intermediate layer 14 may comprise unavoidable impurities due to the raw material component, the film formation step, and the like. In the case of exposure to the air after the film formation of the intermediate layer 14, the presence of oxygen mixed due to the exposure is allowed, which is not particularly limited. The upper limit of the content of the metal is not particularly limited and may be 100 atomic %. The intermediate layer 14 is preferably a layer formed by a physical vapor deposition (PVD) method, more preferably a layer formed by sputtering. The intermediate layer 14 is particularly preferably a layer formed by a magnetron sputtering method using a metal target, from the viewpoint of the uniformity of film thickness distribution. The thickness of the intermediate layer 14 is preferably 10 nm or more and 1000 nm or less, more preferably 30 nm or more and 800 nm or less, further preferably 60 nm or more and 600 nm or less, and particularly preferably 100 nm or more and 400 nm or less. By setting such a thickness, an intermediate layer having a roughness equivalent to that of the carrier can be provided. This thickness is a value measured by analyzing a layer cross section by a transmission electron microscope-energy dispersive X-ray spectrometer (TEM-EDX).

The intermediate layer 14 may have a one-layer configuration or a configuration of two or more layers. When the intermediate layer 14 has a one-layer configuration, the intermediate layer 14 is preferably composed of a layer containing a metal composed of Cu, Al, Ti, Ni, or a combination thereof (for example, an alloy or an intermetallic compound) and is more preferably Al, Ti, or a combination thereof (for example, an alloy or an intermetallic compound), further preferably a layer mainly containing Al or a layer mainly containing Ti. On the other hand, when a metal or an alloy that cannot be said to have sufficiently high adhesion to the carrier 12 is adopted for the intermediate layer 14, the intermediate layer 14 preferably has a two-layer configuration. In other words, by providing adjacent to the carrier 12 a layer composed of a metal (for example, Ti) or an alloy excellent in adhesion to the carrier 12, and providing adjacent to the release layer 16 a layer composed of a metal (for example, Cu) or an alloy poor in adhesion to the carrier 12, the adhesion to the carrier 12 can be improved. Therefore, examples of a preferred two-layer configuration of the intermediate layer 14 include a laminated structure composed of a Ti-containing layer adjacent to the carrier 12, and a Cu-containing layer adjacent to the release layer 16. When the constituent elements and balance of thicknesses of the layers of the two-layer configuration are changed, the release strength also changes, and therefore the constituent elements and thicknesses of the layers are preferably appropriately adjusted. The category of the "metal M-containing layer" herein also includes alloys comprising an element other than the metal M in a range that does not impair the releasability of the carrier. Therefore, the intermediate layer 14 can also be referred to as a layer mainly comprising the metal M. In the above respect, the content of the metal M in the intermediate layer 14 is preferably 50 atomic % or more and 100 atomic % or less, more preferably 60 atomic % or more and 100 atomic % or less, further preferably 70 atomic % or more and 100 atomic % or less, particularly preferably 80 atomic % or more and 100 atomic % or less, and most preferably 90 atomic % or more and 100 atomic % or less.

When the intermediate layer 14 is composed of an alloy, examples of preferred alloys include Ni alloys. The Ni alloy preferably has a Ni content of 45% by weight or more and 98% by weight or less, more preferably 55% by weight or more and 90% by weight or less, and further preferably 65% by weight or more and 85% by weight or less. A preferred Ni alloy is an alloy of Ni and at least one selected from the group consisting of Cr, W, Ta, Co, Cu, Ti, Zr, Si, C, Nd, Nb, and La, more preferably an alloy of Ni and at least one selected from the group consisting of Cr, W, Cu, and Si. When the intermediate layer 14 is a Ni alloy layer, it is particularly preferably a layer formed by a magnetron sputtering method using a Ni alloy target, from the viewpoint of the uniformity of film thickness distribution.

The release layer 16 is a layer that allows or facilitates the release of the carrier 12, and the intermediate layer 14 when it is present. The release layer 16 may be one that can be released by a method in which a physical force is applied, or it may be one that can be released by a method in which laser is used to release the layer (laser lift-off, LLO). When the release layer 16 is composed of a material that can be released by laser lift-off, the release layer 16 may be composed of a resin whose interfacial adhesive strength decreases by irradiation of laser light after curing, or it may be a layer of silicon, silicon carbide, metal oxide, or the like that is modified by irradiation of laser light. The release layer 16 may be either of an organic release layer and an inorganic release layer. Examples of the organic component used for the organic release layer include nitrogen-containing organic compounds, sulfur-containing organic compounds, and carboxylic acids. Examples of the nitrogen-containing organic compounds include triazole compounds and imidazole compounds. On the other hand, examples of the inorganic component used for the inorganic release layer include metal oxides or metal oxynitrides comprising at least one or more of Ni, Mo, Co, Cr, Fe, Ti, W, P, Zn, Cu, Al, Nb, Zr, Ta, Ag, In, Sn, and Ga, or a carbon layer. Among these, particularly, the release layer 16 is preferably a carbon-containing layer, that is, a layer mainly comprising carbon, in terms of ease of release, film-forming properties, and the like, more preferably a layer mainly composed of carbon or a hydrocarbon, and further preferably a layer composed of amorphous carbon, a hard carbon film. In this case, the release layer 16 (that is, a carbon-containing layer) preferably has a carbon concentration of 60 atomic % or more, more preferably 70 atomic % or more, further preferably 80 atomic % or more, and particularly preferably 85 atomic % or more as measured by XPS. The upper limit value of the carbon concentration is not particularly limited and may be 100 atomic % but is practically 98 atomic % or less. The release layer 16 can comprise unavoidable impurities (for example, oxygen and hydrogen derived from the surrounding environment such as an atmosphere). In the release layer 16, metal atoms of types other than the metal contained as the release layer 16 can be mixed due to the film formation method of the functional layer 17 or the metal layer 18. When a carbon-containing layer is used as the release layer 16, the interdiffusivity and reactivity with the carrier are low, and even if the carrier-attached metal foil 10 is subjected to pressing at a temperature of more than 300°C, the formation of metallic bonds between the metal layer and the bonding interface due to high temperature heating can be prevented to maintain a state in which the release and removal of the carrier is easy. This release layer 16 is also preferably a layer formed by a vapor phase method such as sputtering, in terms of suppressing excessive impurities in the release layer 16, and in terms of continuous productivity with the film formation of the optionally provided intermediate layer 14, and the like. The thickness when a carbon-containing layer is used as the release layer 16 is preferably 1 nm or more and 20 nm or less, more preferably 1 nm or more and 10 nm or less. By setting such a thickness, a release layer having a roughness equivalent to that of the carrier and having a release function can be provided. This thickness is a value measured by analyzing a layer cross section by a transmission electron microscope-energy dispersive X-ray spectrometer (TEM-EDX).

The release layer 16 may comprise each layer of a metal oxide layer and a carbon-containing layer or be a layer comprising both a metal oxide and carbon. Particularly, when the laminated sheet 10 comprises the intermediate layer 14, the carbon-containing layer can contribute to the stable release of the carrier 12, and the metal oxide layer can suppress the diffusion of the metal elements derived from the intermediate layer 14 and the metal layer 18, accompanying heating. As a result, even after the carrier-attached metal foil 10 is heated at a temperature as high as, for example, 350°C or more, stable releasability can be maintained. The metal oxide layer is preferably a layer comprising an oxide of a metal composed of Cu, Ti, Al, Nb, Zr, Cr, W, Ta, Co, Ag, Ni, In, Sn, Zn, Ga, Mo, or a combination thereof. The metal oxide layer is particularly preferably a layer formed by a reactive sputtering method in which sputtering is performed under an oxidizing atmosphere, using a metal target, in terms of being able to easily control film thickness by the adjustment of film formation time. The thickness of the metal oxide layer is preferably 0.1 nm or more and 100 nm or less. The upper limit value of the thickness of the metal oxide layer is more preferably 60 nm or less, further preferably 30 nm or less, and particularly preferably 10 nm or less. This thickness is a value measured by analyzing a layer cross section by a transmission electron microscope-energy dispersive X-ray spectrometer (TEM-EDX). At this time, the order in which the metal oxide layer and the carbon layer are laminated as the release layer 16 is not particularly limited. The release layer 16 may be present in a state of a mixed phase in which the boundary between the metal oxide layer and the carbon-containing layer is not clearly identified (that is, a layer comprising both a metal oxide and carbon).

Similarly, from the viewpoint of maintaining stable releasability even after heat treatment at high temperature, the release layer 16 may be a metal-containing layer in which the surface on the side adjacent to the metal layer 18 is a fluorination-treated surface and/or a nitriding-treated surface. In the metal-containing layer, a region in which the sum of the content of fluorine and the content of nitrogen is 1.0 atomic % or more (hereinafter referred to as a "(F + N) region") is preferably present over a thickness of 10 nm or more, and the (F + N) region is preferably present on the metal layer 18 side of the metal-containing layer. The thickness (in terms of SiO₂) of the (F + N) region is a value specified by performing the depth profile elemental analysis of the laminated sheet 10 using XPS. The fluorination-treated surface or the nitriding-treated surface can be preferably formed by Reactive ion etching (RIE) or a reactive sputtering method. On the other hand, the metal element included in the metal-containing layer preferably has a negative standard electrode potential. Preferred examples of the metal element included in the metal-containing layer include Cu, Ag, Sn, Zn, Ti, Al, Nb, Zr, W, Ta, Mo, and combinations thereof (for example, alloys and intermetallic compounds). The content of the metal element in the metal-containing layer is preferably 50 atomic % or more and 100 atomic % or less. The metal-containing layer may be a single layer composed of one layer or a multilayer composed of two or more layers. The thickness of the entire metal-containing layer is preferably 10 nm or more and 1000 nm or less, more preferably 30 nm or more and 500 nm or less, further preferably 50 nm or more and 400 nm or less, and particularly preferably 100 nm or more and 300 nm or less. The thickness of the metal-containing layer itself is a value measured by analyzing a layer cross section by a transmission electron microscope-energy dispersive X-ray spectrometer (TEM-EDX).

Alternatively, the release layer 16 may be a metal oxynitride-containing layer instead of the carbon layer and the like. The surface of the metal oxynitride-containing layer opposite to the carrier 12 (that is, on the metal layer 18 side) preferably comprises at least one metal oxynitride selected from the group consisting of TaON, NiON, TiON, NiWON, and MoON. In terms of ensuring the adhesion between the carrier 12 and the metal layer 18, the surface of the metal oxynitride-containing layer on the carrier 12 side preferably comprises at least one selected from the group consisting of Cu, Ti, Ta, Cr, Ni, Al, Mo, Zn, W, TiN, and TaN. Thus, the number of foreign matter particles on the metal layer 18 surface is suppressed to improve circuit-forming properties, and even after the carrier-attached metal foil 10 is heated at high temperature for a long time, stable release strength can be maintained. The thickness of the metal oxynitride-containing layer is preferably 5 nm or more and 500 nm or less, more preferably 10 nm or more and 400 nm or less, further preferably 20 nm or more and 200 nm or less, and particularly preferably 30 nm or more and 100 nm or less. This thickness is a value measured by analyzing a layer cross section by a transmission electron microscope-energy dispersive X-ray spectrometer (TEM-EDX).

Optionally, the functional layer 17 may be provided between the release layer 16 and the metal layer 18. The functional layer 17 is not particularly limited as long as it provides the desired functions such as an etching stopper function and an antireflection function to the laminated sheet 10. Preferred examples of the metal constituting the functional layer 17 include Ti, Al, Nb, Zr, Cr, W, Ta, Co, Ag, Ni, Mo, and combinations thereof, more preferably Ti, Zr, Al, Cr, W, Ni, Mo, and combinations thereof, further preferably Ti, Al, Cr, Ni, Mo, and combinations thereof, and particularly preferably Ti, Mo, and combinations thereof. These elements have the property of not dissolving in flash etchants (for example, copper flash etchants) and, as a result, can exhibit excellent chemical resistance to flash etchants. Therefore, the functional layer 17 is a layer less likely to be etched with a flash etchant than the metal layer 18, and therefore can function as an etching stopper layer. In addition, the metal constituting the functional layer 17 also has the function of preventing the reflection of light, and therefore the functional layer 17 can also function as an antireflection layer for improving visibility in image inspection (for example, automatic image inspection (AOI)). The functional layer 17 may be a pure metal or an alloy. The metal constituting the functional layer 17 may comprise unavoidable impurities due to the raw material component, the film formation step, and the like. The upper limit of the content of the metal is not particularly limited and may be 100 atomic %. The functional layer 17 is preferably a layer formed by a physical vapor deposition (PVD) method, more preferably a layer formed by sputtering. The thickness of the functional layer 17 is preferably 1 nm or more and 500 nm or less, more preferably 10 nm or more and 400 nm or less, further preferably 30 nm or more and 300 nm or less, and particularly preferably 50 nm or more and 200 nm or less.

The metal layer 18 is a layer composed of a metal. Preferred examples of the metal constituting the metal layer include Cu, Au, Pt, and combinations thereof (for example, alloys and intermetallic compounds), more preferably Cu, Au, Pt, and combinations thereof, and further preferably Cu. The metal constituting the metal layer 18 may comprise unavoidable impurities due to the raw material component, the film formation step, and the like. The metal layer 18 may be manufactured by any method and may be a metal layer formed, for example, by wet film formation methods such as an electroless metal plating method and an electrolytic metal plating method, physical vapor deposition (PVD) methods such as sputtering and vacuum deposition, chemical vapor film formation, or combinations thereof. The metal layer 18 is particularly preferably a metal layer formed by physical vapor deposition (PVD) methods such as a sputtering method and vacuum deposition, from the viewpoint of being easily adapted to a fine pitch due to super-thinning, and most preferably a metal layer manufactured by a sputtering method. The metal layer 18 is preferably a non-roughened metal layer, but may be one in which secondary roughening occurs by preliminary roughening, soft etching treatment, rinse treatment, or oxidation-reduction treatment, as long as wiring pattern formation is not hindered. From the viewpoint of being adapted to a fine pitch as described above, the thickness of the metal layer 18 is 0.01 µm or more and 4.0 µm or less, preferably 0.02 µm or more and 3.0 µm or less, more preferably 0.05 µm or more and 2.5 µm or less, further preferably 0.10 µm or more and 2.0 µm or less, particularly preferably 0.20 µm or more and 1.5 µm or less, and most preferably 0.30 µm or more and 1.2 µm or less. The metal layer 18 having a thickness within such a range is preferably manufactured by a sputtering method from the viewpoint of maintaining the in-plane uniformity of film formation thickness, and improving productivity in a sheet form or a roll form.

The outermost surface of the metal layer 18 preferably has a flat shape corresponding to the surface shape of the flat region F of the carrier 12, and an uneven shape corresponding to the surface shape of the uneven region R of the carrier 12. In other words, as shown in Figures 5 and 6, the metal layer 18 is formed, via the intermediate layer 14 (when present), the release layer 16, and the functional layer 17 (when present), on the carrier 12 having the flat region F and the uneven region R, and thus the surface profiles of the flat region F and uneven region R of the carrier 12 are transferred to the surfaces of the layers. Thus, desirable surface profiles corresponding to the shapes of the regions of the carrier 12 are preferably provided to the outermost surface of the metal layer 18 while the uneven shape is transferred to part of the release layer 16. Thus, it is possible to still further prevent the release of the carrier 12 when the carrier-attached first substrate 20 is cut, and it is possible to be still further adapted to a fine pitch. Typically, the surface having the flat shape corresponding to the flat region F of the carrier 12 (that is, the flat surface) on the outermost surface of the metal layer 18 has a developed interfacial area ratio Sdr of less than 5%, preferably 0.01% or more and 4.0% or less, more preferably 0.03% or more and 3.0% or less, further preferably 0.05% or more and 1.0% or less, and particularly preferably 0.08% or more and 0.50% or less. The surface having the uneven shape corresponding to the uneven region R of the carrier 12 (that is, the uneven surface) on the outermost surface of the metal layer 18 typically has a developed interfacial area ratio Sdr of 5% or more and 39% or less, preferably 6% or more and 36% or less, more preferably 7% or more and 32% or less, further preferably 7% or more and 25% or less, and particularly preferably 8% or more and 22% or less.

The intermediate layer 14 (when present), the release layer 16, the functional layer 17 (when present), and the metal layer 18 are all preferably physical vapor-deposited (PVD) films, that is, films formed by a physical vapor deposition (PVD) method, more preferably sputtered films, that is, films formed by a sputtering method.

It is preferable that the metal layer 18, optionally the intermediate layer 14, optionally the release layer 16, and optionally the functional layer 17 (that is, at least the metal layer 18) extend to the end surfaces of the carrier 12 so that the end surfaces are covered. In other words, not only the surface of the carrier 12 but also the end surfaces are preferably covered with at least the metal layer 18. By covering the end surfaces as well, it is possible to prevent the infiltration of a chemical solution into the carrier 12 in the wiring substrate manufacturing process, and also to firmly prevent chipping due to release at the side ends when handling the laminated sheet 10, that is, chipping of the film on the release layer 16 (that is, the metal layer 18). The coverage region on the end surfaces of the carrier 12 extends from the surface of the carrier 12 toward the thickness direction (that is, the direction perpendicular to the carrier surface), preferably over a region of 0.1 mm or more, more preferably over a region of 0.2 mm or more, and further preferably over the entire end surfaces of the carrier 12.

The thickness of the entire laminated sheet 10 is not particularly limited but is preferably 500 µm or more and 3000 µm or less, more preferably 700 µm or more and 2500 µm or less, further preferably 900 µm or more and 2000 µm or less, and particularly preferably 1000 µm or more and 1700 µm or less. The size of the laminated sheet 10 is not particularly limited but is preferably 10 cm square or more, more preferably 20 cm square or more, and further preferably 25 cm square or more. The upper limit of the size of the laminated sheet 10 is not particularly limited, and an example of one rough standard of the upper limit includes 1000 cm square. The laminated sheet 10 is in a form in which the laminated sheet 10 itself can be handled alone, before and after the formation of resin-containing layer 22.

### EXAMPLES

The present invention will be more specifically described by the following Examples.

The developed interfacial area ratio Sdr mentioned in the following Examples is a value measured by a laser microscope (manufactured by Olympus Corporation, OLS5000) in accordance with ISO 25178. Specifically, the surface profile of a region having an area of 12690 µm² on a surface to be measured was measured by the laser microscope by a 100x lens having a numerical aperture (N.A.) of 0.95. Noise removal and primary linear surface inclination correction were performed on the obtained surface profile, and then the measurement of the developed interfacial area ratio Sdr was carried out by surface property analysis. At this time, in the measurement of Sdr, cutoff by an S filter and an L filter was not performed.

### Example 1

### (1) Fabrication of Laminated Sheet

As shown in Figure 1(i), a carrier made of glass was provided as a carrier 12. An uneven region R was formed on this glass carrier, and then an intermediate layer 14 (a Ti-containing layer and a Cu-containing layer), a carbon-containing layer as a release layer 16, a functional layer 17, and a metal layer 18 were formed in this order to fabricate a laminated sheet 10. The specific procedure is as follows.

### (1-1) Provision of Carrier

A 300 mm square, 1.1 mm thick glass sheet having a flat surface having a developed interfacial area ratio Sdr of 0.10% (material: soda lime glass, manufactured by Central Glass Co., Ltd.) was provided.

### (1-2) Roughening Treatment of Carrier

A masking layer was formed on a carrier 12 surface in a pattern in which four rectangular masking regions were disposed apart from each other with an average line width of 3.0 mm. The formation of this masking layer was performed by roll lamination using a tacky polyvinyl chloride tape (manufactured by LINTEC Corporation, PVC100M M11K). Next, a medium (alumina) having an average particle diameter of 20 µm was projected from a nozzle having a width of 3 mm and a length of 630 mm (the length of the portion overlapping the carrier 12 when seen in a planar view was 200 mm) at a discharge pressure of 0.1 MPa or more and 0.25 MPa or less onto the carrier surface partially covered with the masking layer, using a blasting apparatus (manufactured by Fuji Manufacturing Co., Ltd., product number: SCM-4RBT-05-401), to perform roughening treatment on the exposed portion of the carrier 12. The blasting treatment time per unit area for the carrier 12 was 0.33 seconds/cm². Thus, the uneven region R having a line width of 3.0 mm on average was formed on the carrier 12 surface in a pattern in a lattice form. The developed interfacial area ratio Sdr in the uneven region R of the carrier 12 was 15%.

### (1-3) Formation of Ti-Containing Layer

A 100 nm thick Ti layer as the Ti-containing layer was formed on the carrier 12 surface on the side on which the roughening treatment was performed, by sputtering with the following apparatus and conditions:
- Apparatus: single-wafer magnetron sputtering apparatus (manufactured by Canon Tokki Corporation, MLS464)
- Target: Ti target (purity 99.999%) having diameter of 8 inches (203.2 mm)
- Ultimate vacuum: less than 1 × 10⁻⁴ Pa
- Carrier gas: Ar (flow rate: 100 sccm)
- Sputtering pressure: 0.35 Pa
- Sputtering power: 1000 W (3.1 W/cm²)
- Temperature during film formation: 40°C

### (1-4) Formation of Cu-Containing Layer

A 100 nm thick Cu layer as the Cu-containing layer was formed on the Ti-containing layer by sputtering with the following apparatus and conditions:
- Apparatus: single-wafer DC sputtering apparatus (manufactured by Canon Tokki Corporation, MLS464)
- Target: Cu target (purity 99.98%) having diameter of 8 inches (203.2 mm)
- Ultimate vacuum: less than 1 × 10⁻⁴ Pa
- Carrier gas: Ar (flow rate: 100 sccm)
- Sputtering pressure: 0.35 Pa
- Sputtering power: 1000 W (6.2 W/cm²)
- Temperature during film formation: 40°C

### (1-5) Formation of Carbon-Containing Layer

A 6 nm thick amorphous carbon layer as the release layer 16 was formed on the Cu-containing layer by sputtering with the following apparatus and conditions:
- Apparatus: single-wafer DC sputtering apparatus (manufactured by Canon Tokki Corporation, MLS464)
- Target: carbon target (purity 99.999%) having diameter of 8 inches (203.2 mm)
- Ultimate vacuum: less than 1 × 10⁻⁴ Pa
- Carrier gas: Ar (flow rate: 100 sccm)
- Sputtering pressure: 0.35 Pa
- Sputtering power: 250 W (0.7 W/cm²)
- Temperature during film formation: 40°C

### (1-6) Formation of Functional Layer

A 100 nm thick Ti layer as the functional layer 17 was formed on the surface of the release layer 16 by sputtering with the following apparatus and conditions:
- Apparatus: single-wafer DC sputtering apparatus (manufactured by Canon Tokki Corporation, MLS464)
- Target: Ti target (purity 99.999%) having diameter of 8 inches (203.2 mm)
- Carrier gas: Ar (flow rate: 100 sccm)
- Ultimate vacuum: less than 1 × 10⁻⁴ Pa
- Sputtering pressure: 0.35 Pa
- Sputtering power: 1000 W (3.1 W/cm²)

### (1-7) Formation of Metal Layer

A Cu layer having a thickness of 300 nm as the metal layer 18 was formed on the functional layer 17 by sputtering with the following apparatus and conditions to obtain the laminated sheet 10 (Figure 1(i)).
- Apparatus: single-wafer DC sputtering apparatus (manufactured by Canon Tokki Corporation, MLS464)
- Target: Cu target (purity 99.98%) having diameter of 8 inches (203.2 mm)
- Ultimate vacuum: less than 1 × 10⁻⁴ Pa
- Carrier gas: Ar (flow rate: 100 sccm)
- Sputtering pressure: 0.35 Pa
- Sputtering power: 1000 W (3.1 W/cm²)
- Temperature during film formation: 40°C

### (2) Formation of Resin-Containing Layer

On the surface of the metal layer 18 of the laminated sheet 10, an insulating layer (material: photosensitive epoxy resin) of 300 mm square and 50 µm in thickness was formed as the resin-containing layer 22 to make the carrier-attached first substrate 20 (Figure 1(ii)).

### (3) Cutting of Carrier-Attached First Substrate

Using a commercially available cutting apparatus, the carrier-attached first substrate 20 was cut according to the lattice pattern of the uneven region R (Figure 1(iii)). Specifically, first, the carrier 12 side of the carrier-attached first substrate 20 was fixed to the chuck table of the cutting apparatus. **In** this state, the carrier-attached first substrate 20 was divided by moving the annular cutting blade possessed by the cutting apparatus, while rotating it, from the resin-containing layer 22 side of the carrier-attached first substrate 20 until it reached the carrier 12. This division by the cutting blade was performed according to the lattice pattern of the uneven region R to obtain the individualized carrier-attached first substrate 20' of 60 mm square (Figure 2(iv)). In each individualized carrier-attached first substrate 20', no release of the carrier 12 occurred. Also, the width of the pattern of the uneven region R on the individualized carrier-attached first substrate 20' was 1.5 mm.

### (4) Trimming of Individualized Carrier-Attached First Substrate

Trimming was performed so that the width of the pattern of the uneven region R at the periphery of the individualized carrier-attached first substrate 20' was about 0.3 mm (Figures 2(v) and (vi)). This trimming was performed using the same apparatus and method as for the cutting of the carrier-attached first substrate described above. The above operation was carried out on two individualized carrier-attached first substrates 20'. The four surrounding sides of each carrier-attached first substrate 20' after trimming were each observed with an optical microscope, and the width of the pattern of the uneven region R was measured. The results were as shown in Table 1.

### [Table 1]

**Table 1**

| Serial number | | 1 | 2 |
|---|---|---|---|
| Width of pattern of uneven region (µm) | First side | 328 | 340 |
| | Second side | 334 | 327 |
| | Third side | 321 | 312 |
| | Fourth side | 311 | 271 |

### (5) Lamination of Individualized Carrier-Attached First Substrate onto Second Substrate

A glass epoxy substrate (FR-4) of 80 mm square and 1.6 mm in thickness was provided as the second substrate 30. The individualized carrier-attached first substrate 20' after the above trimming was laminated onto the central portion of the second substrate 30. At this time, by using as the adhesive layer 42 a non-conductive film (NCF) with epoxy resin as the main agent to join the resin-containing layer 22 and the second substrate 30, the composite substrate 40 was made (Figure 3(vii)).

### (6) Release of Carrier

The stage S with a convex curved surface with a radius of curvature of 1500 mm was provided. The obtained composite substrate 40 was placed on the stage S so that the individualized carrier-attached first substrate 20' was on the outside (Figure 10(i)). Then, by pressing opposite corners of the second substrate 30 toward the stage S, the second substrate 30 was made to adhere to the convex curved surface of the stage S (Figure 10(ii)). In this way, the carrier 12 was released from the composite substrate 40 together with the intermediate layer 14 (Figure 10(iii)). The surface of the composite substrate 40 after the release of the carrier 12 was visually observed to confirm that no cracks, tears, or other defects had occurred.

### (7) Removal of Release Layer, Functional Layer, and Metal Layer

The release layer 16 remaining on the composite substrate 40 was removed by ashing. That is, the composite substrate 40 was placed in a chamber for ashing, and after introducing oxygen gas, the oxygen was activated by electric power for plasma generation. This allowed carbon, the main component of the release layer 16, to be bonded with the activated oxygen to form carbon dioxide, thereby removing the release layer 16 as reaction product gas. Thereafter, the functional layer 17 (Ti layer) exposed on the surface of the composite substrate 40 was removed with a hydrogen peroxide-based alkaline etchant, and the metal layer 18 (Cu layer) was also removed with a sulfuric acid-hydrogen peroxide-based etchant. In this way, the composite substrate 40 from which the release layer 16, the functional layer 17, and the metal layer 18 had been removed was obtained (Figure 3(ix)).

## Claims

1. A method for manufacturing a wiring board, comprising the steps of:
providing a laminated sheet comprising a carrier, a release layer, and a metal layer in order, wherein the carrier has a flat region having a developed interfacial area ratio Sdr of less than 5% as measured in accordance with ISO 25178, and an uneven region having a developed interfacial area ratio Sdr of 5% or more and 39% or less as measured in accordance with ISO 25178, on at least a surface on the metal layer side, and wherein the uneven region is provided in a pattern surrounding the flat region;
forming a resin-containing layer on a surface of the metal layer to obtain a carrier-attached first substrate;
cutting the carrier-attached first substrate according to the pattern of the uneven region to obtain an individualized carrier-attached first substrate; and
laminating the individualized carrier-attached first substrate onto a second substrate so that the carrier is on the outside, to obtain a composite substrate.

2. The method for manufacturing a wiring board according to claim 1,
wherein a width of the pattern of the uneven region in the laminated sheet is more than 1.0 mm, and
wherein the method for manufacturing a wiring board further comprises the step of trimming the individualized carrier-attached first substrate so that the width of the pattern of the uneven region at a periphery of the individualized carrier-attached first substrate is 1.0 mm or less all around, before laminating the individualized carrier-attached first substrate onto the second substrate.

3. The method for manufacturing a wiring board according to claim 1 or 2, further comprising the steps of:
placing the composite substrate on a stage so that the individualized carrier-attached first substrate is on the outside, to make the second substrate adhere to the stage; and
releasing the carrier from the release layer so that the second substrate forms a convex curved surface with a radius of curvature of 200 mm or more and 5000 mm or less, while making the second substrate adhere to the stage.

4. The method for manufacturing a wiring board according to claim 1 or 2, wherein the carrier-attached first substrate has a thickness of 150 µm or more and 3000 µm or less, and the second substrate has a thickness of 300 µm or more and 3000 µm or less.

5. The method for manufacturing a wiring board according to claim 1 or 2, wherein the carrier has a plurality of the flat regions, and wherein the uneven region is provided in a linear pattern defining the flat regions.

6. The method for manufacturing a wiring board according to claim 1 or 2, wherein the carrier is composed of glass, silicon, ceramics, or metal.

7. The method for manufacturing a wiring board according to claim 1 or 2, wherein the resin-containing layer comprises a wiring layer and an insulating layer.

8. The method for manufacturing a wiring board according to claim 7, wherein the insulating layer is composed of an insulating resin.

9. The method for manufacturing a wiring board according to claim 7, wherein the step of forming the resin-containing layer comprises the steps of:
forming a first wiring layer on a surface of the metal layer; and
alternately forming an insulating layer and a wiring layer on the surface of the laminated sheet on which the first wiring layer has been formed, to obtain a resin-containing layer in which the first wiring layer is incorporated in a form of an embedded wiring layer.

10. The method for manufacturing a wiring board according to claim 7, wherein the resin-containing layer is an interposer.

11. The method for manufacturing a wiring board according to claim 1 or 2, wherein the second substrate is a build-up substrate.

12. The method for manufacturing a wiring board according to claim 1 or 2, wherein the second substrate comprises a core layer, and wherein the core layer is composed of at least one selected from the group consisting of epoxy resin, bismaleimide-triazine resin, FR-4, FR-5, cyanate ester, polyphenylene derivative, glass, prepreg material, polyimide, polyamide, liquid crystal polymer, epoxy-based build-up material, polytetrafluoroethylene, ceramics, and metal oxide.

13. The method for manufacturing a wiring board according to claim 12, wherein the second substrate comprises a wiring layer and an insulating layer on at least one surface of the core layer.

14. The method for manufacturing a wiring board according to claim 1 or 2, wherein in the laminated sheet, an outermost surface of the metal layer has a flat shape corresponding to a surface shape of the flat region of the carrier, and an uneven shape corresponding to a surface shape of the uneven region of the carrier.
